# EUROPEAN PATENT SPECIFICATION

(11) **EP 0 341 732 B1**
(45) Date of publication and mention of the grant of the patent: **28.02.1996**
(21) Application number: 89108588.8
(22) Date of filing: 12.05.1989
(51) Int. Cl.: H03K 19/086

(54) **Logic circuit**
Logische Schaltung
Circuit logique

(30) Priority: 13.05.1988 JP 117627/88
(43) Date of publication of application: 15.11.1989
(73) Proprietor: FUJITSU LIMITED, Kawasaki-shi, Kanagawa 211 (JP)
(72) Inventor: Shimotsuhama, Isao c/o FUJITSU LIMITED, Nakahara-ku Kawasaki-shi Kanagawa 211 (JP); Emori, Shinji c/o FUJITSU LIMITED, Nakahara-ku Kawasaki-shi Kanagawa 211 (JP); Watanabe, Yoshio c/o FUJITSU LIMITED, Nakahara-ku Kawasaki-shi Kanagawa 211 (JP); Tamamura, Masaya c/o FUJITSU LIMITED, Nakahara-ku Kawasaki-shi Kanagawa 211 (JP)
(74) Representative: Sunderland, James Harry

(56) References cited:
- EP-A- 0 167 339
- WO-A-88/00414
- DE-A- 1 230 079
- GB-A- 2 012 137
- GB-A- 2 110 029

## Description

The present invention relates to logic circuits, and more particularly to differential-input type logic circuits.

Differential-input type logic circuits, for instance emitter-coupled logic (referred to hereinafter as ECL) circuits or current-mode logic (CML) circuits, have been widely employed because of their high-speed switching capability.

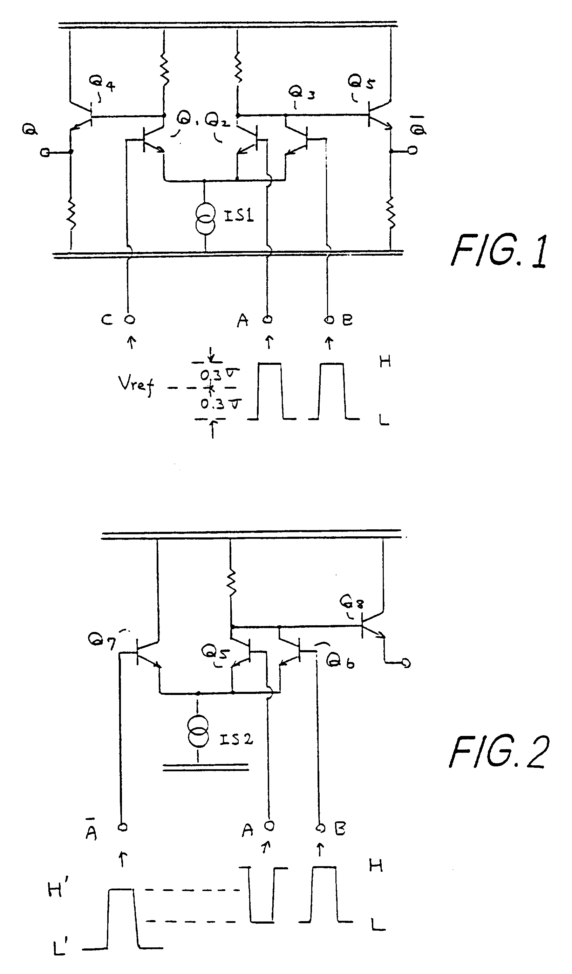

When constituting an ECL logic circuit, such as a high-speed clock-pulse distributor, a first transistor Q₁ of two paired transistors forming an ECL circuit has a reference voltage V_{ref} input (input C), and a second transistor Q₂ of the two paired transistors, having an input A, is generally provided with an additional, third transistor Q₃ in parallel thereto, as shown in Fig. 1, which third transistor Q₃ has an input B. In order to provide an effective input voltage difference between differential inputs A and C, it is required that a logical high level (referred to hereinafter as H level) and a logical low level (referred to hereinafter as L level) of input signals A and B to the second and third transistors Q₂ and Q₃ are typically 0.3 V higher and lower than the reference voltage V_{ref}, in other words, peak-to-peak 0.6 V, as shown in Fig. 1, where input signal levels are illustrated by pulse forms drawn below the corresponding input terminals. The 0.3 V differences from the reference voltage V_{ref} are required for the switching of current flowing through the paired transistors by only one of the input signals, allowing a margin for noise. In this example, clock pulses are input to the second transistor Q₂ (input A). The clock signal is enabled/disabled by input signal B taking L/H levels as input to the third transistor Q₃.

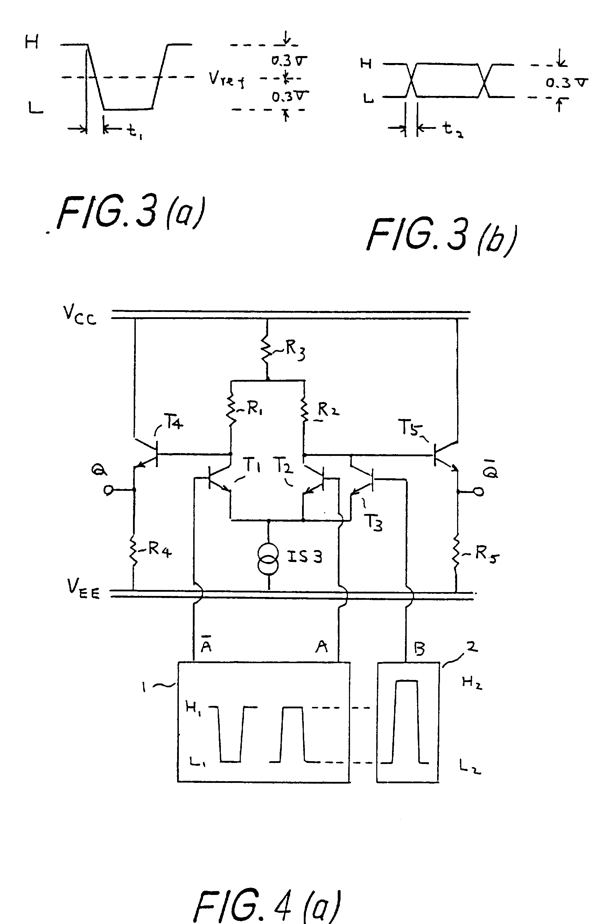

The method involving employment of a reference voltage is referred to hereinafter as a reference voltage method, and is disadvantageous in terms of high-speed switching of the clock pulse in the case of the above logic circuit, because, as shown in Fig. 3(a), rise/fall time t₁ of the 0.6 V peak-to-peak input signal is, roughly speaking, twice the rise/fall time t₂ of a 0.3 V peak-to-peak input signal, as shown in Fig. 3(b), required by an ordinary ECL circuit having no reference voltage, where the paired transistors perform a full differential operation; that is, when one of the base electrode voltages is increased the other base electrode voltage is decreased.

Another ECL-type logic circuit having a plurality of logical input signals thereto and having different input voltage levels is illustrated in Fig. 2, which is derived from the description of a preferred embodiment disclosed in U.S. Patent 4 745 582 (Fukushi, et al). In the Figure, an ECL circuit is composed of: first and second transistors Q₅ and Q₆ connected in parallel; a third transistor Q₇; and a current source IS2 connected to the emitters of the three transistors Q₅, Q₆ and Q₇. Collectors of the parallel-connected transistors Q₅ and Q₆ are connected together to a power source V_{CC} line through a resistor, whereby the result of the logic operation is output to an output transistor Q₈. The collector electrode of the third transistor Q₇ is directly connected to the power source V_{CC} line. In the cited U.S. patent, OR/NOR operation of inputs A and B, applied to the first and second transistors Q₅ and Q₆, respectively, is enabled when the input ($\overline{\text{A}}$) to the third transistor Q₇ is high (this "high" level being chosen to lie between high and low levels of the inputs A and B); and the OR/NOR operation of the inputs A and B is disabled when the input ($\overline{\text{A}}$) to the third transistor Q₇ is low (this "low" being chosen lower than the low level of the inputs A and B). The high level of the input to the third transistor Q₇ acts as a reference voltage for the inputs A and B, which accordingly must have peak-to-peak 0.6 V amplitude. Now, assuming that an attempt is made to utilise this circuit as a clock pulse distributor, then complementary clock pulses are input to the first and third transistors Q₅ and Q₇, as shown in Fig. 2, where signal levels to the input terminals are illustrated in the same way as in Fig. 1. The term "complementary" is used in the last sentence to express the fact that the two signals are seesawing though the levels involved are not symmetric, as described below. Signal levels of the input $\overline{\text{A}}$ to the third transistor Q₇ are chosen such that its high level H' is between high and low levels H and L of the inputs A/B to the first/second transistors Q₅/Q₆, and such that its low level L' is lower than the low level L of the inputs A/B. Levels H/L of the input B to the second transistor Q₆ disable/enable the clock pulses A/$\overline{\text{A}}$. When enabled by a low level L applied to input B (to the second transistor Q₆) the low level L acts as a reference voltage for the third transistor Q₇. Accordingly, the amplitudes of the inputs A and $\overline{\text{A}}$, i.e. the clock pulse, must be as large as 0.6 V, which causes the same disadvantageous problem as is described for the circuit of Fig. 1. When the input B to the second transistor Q₆ is at the high level H, the output of the ECL is always low regardless of the logical levels of the inputs A and A (to the first and third transistors Q₅ and Q₇) and thus output of clock pulses is disabled.

DE-A-1 230 079 discloses a logic circuit having the features of the preamble of accompanying claim 1. This logic circuit is a bistable multivibrator having a driving circuit in the form of a pair of feedback transistors within the multivibrator for producing a latch effect. Set and reset inputs of the multivibrator are supplied with voltage levels different from those supplied by the feedback transistors.

According to the present invention there is provided a logic circuit comprising:-
a differential amplifier having a transistor pair of first and second transistors connected to an output stage;
a third transistor connected in parallel with the second transistor; and
a first driving circuit operatively connected to drive the first and second transistors with complementary driving signals having first and second levels;
and wherein the third transistor is arranged to be driven by another driving signal having third and fourth levels, wherein the third level is beyond one end of the range between the first and second levels; characterised in that:-
a second driving circuit is operatively connected to drive the third transistor with said another driving signal having said third and fourth levels;
both of said first and second driving circuits are provided independently of said differential amplifier, without being connected to the output stage, so as to allow selection of the levels of said driving signals;
and in that the levels of said driving signals are selected such that the fourth level is either substantially equal to, or beyond, the other end of the range between the first and second levels.

An embodiment of the present invention can provide a high-speed differential-input type logic circuit, for instance an ECL/CML-type logic circuit, operating with a plurality of logical inputs thereto.

In an embodiment of the present invention, one of two paired transistors, which form an ECL/CML-type differential amplifier and which are driven by complementary pulse signals, is provided with at least one additional transistor in parallel thereto. The additional transistor has as its input, for instance, a signal whose high level is effectively higher than the high level of input signals of the paired transistors forming the ECL/CML, and whose low level is effectively lower than the high level of input signals of the paired transistors. When the input to the additional transistor takes its low level, the paired transistors perform a differential operation so as to output the complementary inputs (provide outputs corresponding to the complementary pulse input signals). When the input to the additional transistor takes its high level, the paired transistors are dominated by the high level input to the additional transistor; accordingly, the output of signals corresponding to the complementary input signals to the paired transistors is disabled. The above-described circuit maintains the advantage of the high-speed switching capability of ECL/CML circuitry to amplify the complementary signals.

Reference is made, by way of example, to the accompanying drawings, in which:-
Fig. 1 shows a previously proposed ECL circuit having a plurality of logical inputs and employing a reference voltage;
Fig. 2 shows another previously proposed ECL circuit having a plurality of logical inputs,
Fig. 3(a) illustrates signal levels and rise/fall times of input signals in relation to an ECL circuit using a reference voltage method,
Fig. 3(b) illustrates signal levels and rise/fall times of input signals in relation to an ECL circuit employing no reference voltage,
Fig. 4(a) illustrates an ECL circuit in accordance with an embodiment of the present invention,
Fig. 4(b) illustrates a first driving circuit for connection to the ECL circuit of Fig. 4(a),
Fig. 4(c) illustrates a second driving circuit for connection to the ECL circuit of Fig. 4(a), to input a larger signal than the first driving circuit,
Fig. 5 illustrates an alternative possible variation of signal levels of the output of the second driving circuit,
Fig. 6 is a truth table of logic operation of the circuit of Fig. 4(a),
Fig. 7 illustrates an ECL circuit in accordance with another embodiment of the present invention,
Fig. 8 is a truth table of logic operation of the circuit of Fig. 7.
Fig. 9 illustrates a circuit in accordance with another embodiment of the present invention, the circuit employing GaAs source-coupled FET logic,
Fig. 10 is a logic diagram of a clock pulse distributor employing circuits in accordance with an embodiment of the present invention, and
Fig. 11 is a truth table of logic operation of the circuit of Fig. 10.

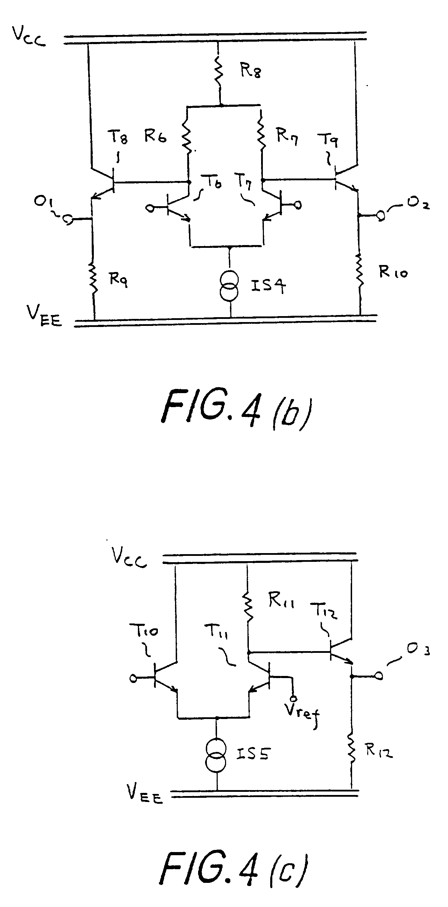

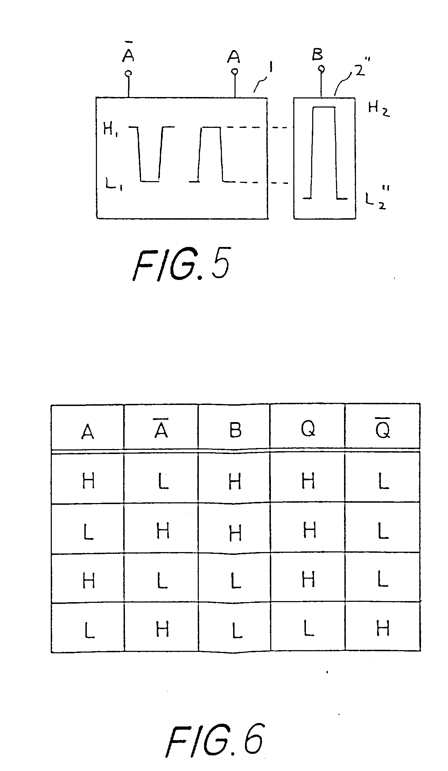

With reference to the circuit diagrams of Fig. 4(a) to 4(c), and the truth table in Fig. 6, an embodiment of the present invention will hereinafter be described in some detail.

First and second transistors T₁ and T₂ are paired to form a CML-type differential amplifier, and a third transistor T₃ is additionally connected in parallel with the second transistor T₂. Emitter electrodes of the three transistors T₁, T₂ and T₃ are connected together to (one terminal of) a constant-current source IS3, whose opposite terminal is connected to a negative terminal V_{EE} line, for example at -5.2 V, of a direct current (DC) power source (not shown in the Figures).

The constant-current source IS3 allows a constant DC current flow of, for example, 1 mA. Details of the constant-current source IS3 are not shown. The source may be composed, for instance, of a transistor having a resistor serially connected to its emitter electrode and having a constant voltage applied to its base electrode. The source may alternatively be a resistor.

A resistor R₁ having, for example, a resistance value 300 ohms, is connected between one end of a common resistor R₃ having, for example, a resistance value 300 ohms and collector electrode of the first transistor T₁. The other end of the common resistor R₃ is connected to a positive terminal V_{CC} line, for example at 0 V, of the DC power source. A resistor R₂ having a resistance value of, for example, 300 ohms, is connected between the said one end of the common resistor R₃ and collector electrodes of the second and third transistors T₂ and T₃. Collector electrodes of the first and second transistors T₁ and T₂ (T₃) are respectively connected to base electrodes of fourth and fifth transistors T₄ and T₅, having respective resistors R₄ and R₅ serially connected to their emitter electrodes. Thus, signals generated at the collector electrodes of transistors T₁ and T₂ (T₃) are amplified and output as output signals Q and $\overline{\text{Q}}$ from respective emitter electrode of the fourth and fifth transistors T₄ and T₅.

The base electrodes of the first and second transistors T₁ and T₂ are respectively connected to output terminals O₁ and O₂ of a first driving circuit 1 shown in Fig. 4(b), which also has an ECL configuration.

In the first driving circuit 1, emitter electrodes of sixth and seventh transistors T₆ and T₇, which are paired together, are connected together to a constant current source IS4, allowing a flow of, for example, 1mA, composed for instance in the same way as the constant current source IS3 of Fig. 4(a). Collector electrodes of T₆ and T₇ are connected to resistors R₆ and R₇, each having a resistance value of, for example, 300 ohms, which are in turn connected to one end of a common resistor R₈ having a resistance value of, for example, 300 ohms, the other end of which is connected to the DC power source V_{CC} line. Output transistors T₈ and T₉ and resistors R₉ and R₁₀ are provided in a configuration similar to that of transistors T₄ and T₅ and resistors R₄ and R₅ in Fig. 4(a).

Base electrode of third transistor T₃ (Fig. 4(a)) is connected to an output terminal O₃ of a second driving circuit 2 which is illustrated in Fig. 4(c) and which also has an ECL configuration.

In the second driving circuit 2, emitter electrodes of tenth and eleventh transistors T₁₀ and T₁₁, which are paired together, are connected together to a constant current source IS5 allowing a flow of, for example, 1 mA, composed for instance in the same way as the current source IS3 of Fig. 4(a). A resistor R₁₁ having a resistance value of, for example, 600 ohms connects the collector electrode of the eleventh transistor T₁₁ to the DC power source V_{CC} line. The collector electrode of the tenth transistor T₁₀ is directly connected to the DC power source V_{CC} line. An output transistor T₁₂ and a resistor R₁₂ are configured in a similar way to transistor T₅ and resistor R₅ in Fig. 4(a).

Signal levels of the outputs from the terminals O₁ and O₂ of the first driving circuit 1, i.e. the inputs A and $\overline{\text{A}}$ to the first and second transistors T₁ and T₂, are such that the high level H₁ is typically -1.2 V, and the low level L₁ is typically -1.5 V. Signal levels of the output from the terminal O₃ of the second driving circuit 2, i.e. the input B to the third transistor T₃, are such that the high level H₂ is typically -900 mV, which is 300 mV higher than the high level H₁ of the signals A/$\overline{\text{A}}$ of the first driving circuit 1, and the low level L₂ is typically -1.5 V, which is essentially the same as the low level L₁ of the signals input A and $\overline{\text{A}}$ to the first and second transistors T₁ and T₂. The amount 300 mV is provided as an effective difference from the high level of the input signals A/$\overline{\text{A}}$ so as to make allowances for possible problems caused by noise or transitions. The levels of the input signals A, $\overline{\text{A}}$ and B are illustrated in blocks corresponding to the relevant driving circuits drawn below corresponding input terminals in Fig. 4(a) for comparison.

When the input B to the third transistor T₃ is of low level L₂, the third transistor T₃ has no effect on the differential operation of the first and second transistors T₁ and T₂, and the complementary signal inputs, for example in this case clock pulses, A and $\overline{\text{A}}$ are output as Q and $\overline{\text{Q}}$, in other words, output of the clock signal is enabled.

When the input B to the third transistor T₃ is of high level H₂, the third transistor T₃ dominates over the high level H₁ input to the first transistor T₁. Consequently, current is switched from the first transistor T₁ to flow in the third transistor T₃. Thus in this state, output of the complementary input signals, i.e. the clock pulses, A and $\overline{\text{A}}$ is disabled. Furthermore, the inputs A and B perform an OR/NOR operation. Results of these logic operations are shown in the truth table of Fig. 6.

Although, in the above-described embodiment, the low level L₂ of the input B is chosen essentially the same as the low level L₁ of the inputs A and $\overline{\text{A}}$, the low level L₂ of the input B may be chosen lower, as denoted by L₂'' in Fig. 5, than the low level L₁ of the inputs A and $\overline{\text{A}}$, as long as the low level L₂'' is effectively lower than the high level H₁ of the inputs A and $\overline{\text{A}}$, as described previously.

Selection of an appropriate low level (L₂ or L₂'') is determined as a compromise between the required switching speeds of the signal A/$\overline{\text{A}}$ and the signal B depending upon circuit requirements. In an application to a clock pulse distributor, the clock pulse switching has priority over the switching speed of the enable/disable signal pulse B. Therefore, the amplitude of the enable/disable signal pulse B is generally chosen larger than the clock signal pulse A/$\overline{\text{A}}$ (consequently the rise/fall time of the enable /disable signal pulse B is generally longer than the rise/fall time(s) of the clock signal pulse A/$\overline{\text{A}}$. Moreover, in a clock pulse distributor, even though the amplitude of the enable/disable signal pulse B is chosen larger than that of the clock signal pulse A/$\overline{\text{A}}$, operation speed of the circuit as a whole is not deteriorated because the frequency of the clock signal pulse A/$\overline{\text{A}}$ is incomparably higher than that of the enable/disable signal.

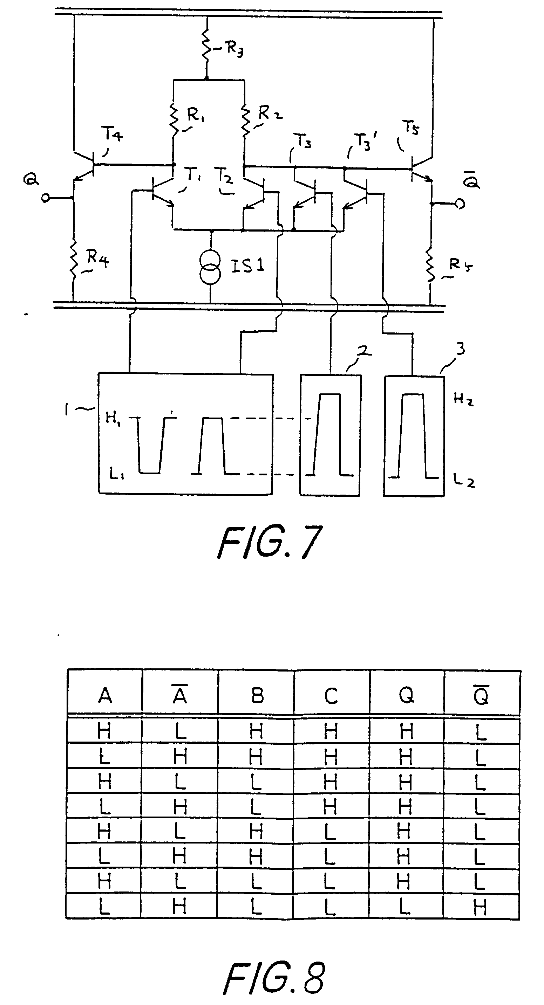

A second embodiment of the present invention is illustrated in the circuit diagram in Fig. 7 and a truth table in Fig. 8.

The circuit of the second embodiment is the same as that of the first embodiment shown in Fig. 4(a) except that a further additional transistor T₃′, connected to a further driving circuit 3, is provided in parallel to the third transistor T₃. The base electrode of the further additional transistor T₃′ is connected to the third driving circuit 3 which is of the same constitution as and has the same output levels as the second driving circuit 2. Accordingly, a high level of input C to the transistor T₃′ dominates the operation of the first and second transistors T₁ and T₂, as well. Thus, the three inputs A, B and C perform an OR/NOR operation. Results of these logic operations are shown in the truth table of Fig. 8.

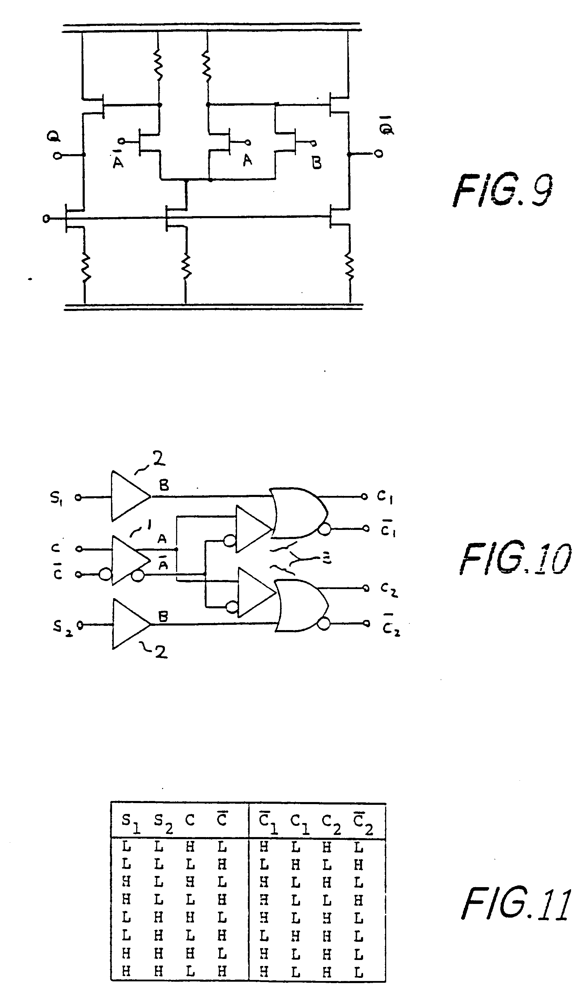

Although in the above-described embodiments of the present invention the ECL circuits are indicated to be composed of bipolar transistors, it will be apparent that embodiments of the present invention can be applied also to other transistor types, for example to a source-coupled FET logic (SCFL) circuit composed of gallium arsenide (GaAs) FETs (field effect transistors) as shown in Fig. 9, which corresponds to the upper half of the circuit shown in Fig. 4(a).

An application of an embodiment of the present invention to a clock pulse distributor for branching clock pulses is illustrated in a logic diagram in Fig. 10 and a truth table in Fig. 11.

In Fig. 10, blocks 1 and 2 represent first and second driving circuits 1 and 2, respectively. Block 3 represents the ECL circuit shown in the upper half of Fig. 4(a). The signals A, $\overline{\text{A}}$ and B correspond to those of Figs. 4. A complementary clock pulse signal C/$\overline{\text{C}}$ is branched to two groups C₁/$\overline{\text{C}}$₁ and C₂/$\overline{\text{C}}$₂. Each of signals S₁ and S₂ enables/disables the output clock pulse C₁/$\overline{\text{C1}}$ and C₂/$\overline{\text{C}}$₂, respectively. Results of the logic operation of the clock pulse distributor are shown in truth table of Fig. 11.

As described above, the distribution of a high-speed clock pulse can be controlled by signals S₁ and S₂, respectively, while reserving the advantage of the high-speed ECL configuration. A circuit configuration in accordance with an embodiment of the present invention can be advantageous particularly in a standard cell type LSI (large-scale integrated circuit), where an unused output terminal of the clock pulse distributor must be kept at a DC voltage so that noise radiation therefrom is prevented. If a circuit configuration not having the signal level conditions of an embodiment of the present invention is employed, the reference voltage method must be employed, where the input clock pulse amplitude must be large, resulting in deterioration of operation speed of the entire LSI.

Pulse delay time of the output pulse from the input pulse A to transistors T₁ and T₂ in the circuit of Fig. 4(a) can be as short as 80 ps, compared with a delay time of 100 ps for the circuit of Fig. 1. As a result, clock pulse frequency can be increased with the embodiment of the present invention.

Although in the above-described embodiments of the present invention the ECL circuits are shown composed of NPN transistors, it is apparent that embodiments of the present invention can be applied to ECL/CML circuits composed of PNP transistors, where the condition "the level H₂ is higher than the other high-level H₁" is replaced with a condition "a low-level L₂ of the input B is lower than the low-level L₁ of the complementary inputs A/$\overline{\text{A}}$", so that the third transistor can dominate over the first transistor, etc.

Although in the above-described embodiments of the present invention the circuits have an ECL configuration with two output transistors T₄ and T₅, providing output signals Q and $\overline{\text{Q}}$ respectively, it is apparent that embodiments of the present invention can be applied to circuits having both or either of the two output transistors T₄ and T₅ omitted.

The voltage levels and the resistance values, etc., referred to in the above-description of embodiments of the present invention are given only by way of example. It will be apparent that these circuit values can be arbitrarily modified according to circuit requirements, and that the common resistor, such as R₃ or R₈, can be omitted, as long as the level conditions of the present invention are satisfied.

## Claims

1. A logic circuit comprising:-
a differential amplifier having a transistor pair of first and second transistors (T₁, T₂) connected to an output stage (T₄, T₅);
a third transistor (T₃; T₃, T₃') connected in parallel with the second transistor (T₂) ; and
a first driving circuit (1) operatively connected to drive the first and second transistors (T₁, T₂) with complementary driving signals ($\overline{\text{A}}$, A) having first and second levels (L₁, H₁);
and wherein the third transistor (T₃; T₃, T₃') is arranged to be driven by another driving signal (B; B, C) having third and fourth levels (L₂, H₂), wherein the third level (e.g. H₂) is beyond one end of the range between the first and second levels (L₁, H₁) ;
characterised in that:-
a second driving circuit (2; 2, 3) is operatively connected to drive the third transistor (T₃; T₃, T₃') with said another driving signal (B; B, C) having said third and fourth levels;
both of said first and second driving circuits are provided independently of said differential amplifier, without being connected to the output stage, so as to allow selection of the levels of said driving signals ($\overline{\text{A}}$, A; B; B, C);
and in that the levels of said driving signals are selected such that the fourth level (e.g. L₂) is either substantially equal to, or beyond, the other end of the range between the first and second levels (L₁, H₁).

2. A logic circuit as claimed in claim 1, wherein a high level (H₂) of said another driving signal (B; B, C) of the second driving circuit (2; 2, 3) is effectively higher than a high level (H₁) of said complementary driving signals ($\overline{\text{A}}$, A) of the first driving circuit (1).

3. A logic circuit as claimed in claim 2, wherein the low level (L₂) of said another driving signal (B; B, C) of the second driving circuit is substantially equal to the low level (L₁) of said complementary driving signals ($\overline{\text{A}}$, A) of said first driving circuit (1).

4. A logic circuit as claimed in claim 2, wherein the low level (L₂) of said another driving signal (B; B, C) of the second driving circuit (2; 2, 3) is lower than the low level (L₁) of said complementary driving signals ($\overline{\text{A}}$, A) of the first driving circuit (1).

5. A logic circuit as claimed in claims 2, 3 or 4, wherein the said transistors (T₁, T₂, T₃, T₃') are NPN transistors.

6. A logic circuit as claimed in claim 1, wherein the said transistors (T₁, T₂, T₃, T₃') are PNP transistors, and wherein a low level (L₂) of said another driving signal (B; B, C) of the second driving circuit (2; 2, 3) is effectively lower than a low level (L₁) of said complementary driving signals ($\overline{\text{A}}$, A) of the first driving circuit (1).

7. A logic circuit as claimed in claim 6, wherein the high level (H₂) of said another driving signal (B; B, C) of the second driving circuit (2; 2, 3) is substantially equal to the high level (H₁) of the complementary driving signals ($\overline{\text{A}}$, A) of the first driving circuit (1).

8. A logic circuit as claimed in claim 6, wherein the high level (H₂) of said another driving signal (B; B, C) of the second driving circuit (2; 2, 3) is higher than the high level (H₁) of said complementary driving signals ($\overline{\text{A}}$, A) of the first driving circuit (1).

9. A logic circuit as claimed in any one of claims 5 to 8, wherein emitters of the first, second and third transistors (T₁, T₂, T₃, T₃') are operatively connected with each other, and connected to an essentially constant-current source (IS3, IS1).

10. A logic circuit as claimed in claim 9, wherein the essentially constant-current source (IS3, IS1) comprises a fourth transistor having a resistor serially connected to an emitter electrode of the fourth transistor and an essentially constant voltage applied to a base electrode of the fourth transistor.

11. A logic circuit as claimed in claim 9, wherein the essentially constant-current source (IS3, IS1) comprises a resistor.

12. A logic circuit as claimed in any one of claims 5 to 11, wherein a resistor (R₁, R₂) is connected between a collector power source (V_{cc}) and one of the collectors of the first and second transistors (T₁, T₂), whereby a logic signal is output from the collector connected to the said resistor.

13. A logic circuit as claimed in any preceding claim, wherein the rise time and fall time of said another driving signal (B; B, C) of the second driving circuit (2; 2, 3) are longer than the rise time and fall time of said complementary driving signals ($\overline{\text{A}}$, A) of the first driving circuit (1).

14. A logic circuit as claimed in any preceding claim, wherein the frequency of said another driving signal (B; B, C) of the second driving circuit (2; 2, 3) is lower than the frequency of said complementary driving signals ($\overline{\text{A}}$, A) of the first driving circuit (1).

15. A logic circuit as claimed in claim 1, wherein the said transistors (T₁, T₂, T₃, T₃') are GaAs FETs.

## Patentansprüche

1. Eine Logikschaltung mit:-
einem Differenzverstärker, der ein Transistorpaar von ersten und zweiten Transistoren (T₁, T₂) hat, die mit einer Ausgangsstufe (T₄, T₅) verbunden sind;
einem dritten Transistor (T₃; T₃, T₃'), der mit dem zweiten Transistor (T₂) parallel verbunden ist; und
einer ersten Treiberschaltung (1), die operativ verbunden ist, um die ersten und zweiten Transistoren (T₁, T₂) mit komplementären Treibersignalen ($\overline{\text{A}}$, A) zu steuern, die erste und zweite Pegel (L₁, H₁) haben;
und bei der der dritte Transistor (T₃; T₃, T₃') angeordnet ist, um durch ein anderes Treibersignal (B; B, C) gesteuert zu werden, das dritte und vierte Pegel (L₂, H₂) hat, welcher dritte Pegel (z. B. H₂) über einem Ende des Bereichs zwischen den ersten und zweiten Pegeln (L₁, H₁) liegt;
dadurch gekennzeichnet, daß:-
eine zweite Treiberschaltung (2; 2, 3) operativ verbunden ist, um den dritten Transistor (T₃; T₃, T₃') mit dem genannten anderen Treibersignal (B; B, C) zu steuern, welches die genannten dritten und vierten Pegel hat;
beide der genannten ersten und zweiten Treiberschaltungen unabhängig von dem genannten Differenzverstärker vorgesehen sind, ohne mit der Ausgangsstufe verbunden zu sein, um die Selektion der Pegel der genannten Treibersignale ($\overline{\text{A}}$, A; B; B, C) zu gestatten;
und daß die Pegel der genannten Treibersignale so selektiert sind, daß der vierte Pegel (z. B. L₂) entweder dem anderen Ende des Bereichs zwischen den ersten und zweiten Pegeln (L₁, H₁) im wesentlichen gleich ist oder über ihm liegt.

2. Eine Logikschaltung nach Anspruch 1, bei der ein hoher Pegel (H₂) des genannten anderen Treibersignals (B; B, C) der zweiten Treiberschaltung (2; 2, 3) effektiv höher ist als ein hoher Pegel (H₁) der genannten komplementären Treibersignale ($\overline{\text{A}}$, A) der ersten Treiberschaltung (1).

3. Eine Logikschaltung nach Anspruch 2, bei der der niedrige Pegel (L₂) des genannten anderen Treibersignals (B; B, C) der zweiten Treiberschaltung im wesentlichen gleich dem niedrigen Pegel (L₁) der genannten komplementären Treibersignale ($\overline{\text{A}}$, A) der genannten ersten Treiberschaltung (1) ist.

4. Eine Logikschaltung nach Anspruch 2, bei der der niedrige Pegel (L₂) des genannten anderen Treibersignals (B; B, C) der zweiten Treiberschaltung (2; 2, 3) niedriger ist als der niedrige Pegel (L₁) der genannten komplementären Treibersignale ($\overline{\text{A}}$, A) der ersten Treiberschaltung (1).

5. Eine Logikschaltung nach den Ansprüchen 2, 3 oder 4, bei der die genannten Transistoren (T₁, T₂, T₃, T₃') NPN-Transistoren sind.

6. Eine Logikschaltung nach Anspruch 1, bei der die genannten Transistoren (T₁, T₂, T₃, T₃') PNP-Transistoren sind, und bei der ein niedriger Pegel (L₂) des genannten anderen Treibersignals (B; B, C) der zweiten Treiberschaltung (2; 2, 3) effektiv niedriger ist als ein niedriger Pegel (L₁) der genannten komplementären Treibersignale (A, A) der ersten Treiberschaltung (1).

7. Eine Logikschaltung nach Anspruch 6, bei der der hohe Pegel (H₂) des genannten anderen Treibersignals (B; B, C) der zweiten Treiberschaltung (2; 2, 3) im wesentlichen gleich dem hohen Pegel (H₁) der komplementären Treibersignale ($\overline{\text{A}}$, A) der ersten Treiberschaltung (1) ist.

8. Eine Logikschaltung nach Anspruch 6, bei der der hohe Pegel (H₂) des genannten anderen Treibersignals (B; B, C) der zweiten Treiberschaltung (2; 2, 3) höher ist als der hohe Pegel (H₁) der genannten komplementären Treibersignale ($\overline{\text{A}}$, A) der ersten Treiberschaltung (1).

9. Eine Logikschaltung nach irgendeinem der Ansprüche 5 bis 8, bei der Emitter der ersten, zweiten und dritten Transistoren (T₁, T₂, T₃, T₃') operativ miteinander verbunden sind und mit einer im wesentlichen konstanten Stromquelle (IS3, IS1) verbunden sind.

10. Eine Logikschaltung nach Anspruch 9, bei der die im wesentlichen konstante Stromquelle (IS3, IS1) einen vierten Transistor umfaßt, der einen Widerstand hat, der mit einer Emitterelektrode des vierten Transistors seriell verbunden ist, und eine im wesentlichen konstante Spannung, die auf eine Basiselektrode des vierten Transistors angewendet wird.

11. Eine Logikschaltung nach Anspruch 9, bei der die im wesentlichen konstante Stromquelle (IS3, IS1) einen Widerstand umfaßt.

12. Eine Logikschaltung nach irgendeinem der Ansprüche 5 bis 11, bei der ein Widerstand (R₁, R₂) zwischen einer Kollektorenergiequelle (V_{cc}) und einem der Kollektoren der ersten und zweiten Transistoren (T₁, T₂) verbunden ist, wodurch ein logisches Signal von dem Kollektor ausgegeben wird, der mit dem genannten Widerstand verbunden ist.

13. Eine Logikschaltung nach irgendeinem vorhergehenden Anspruch, bei der die Anstiegszeit und Abfallzeit des genannten anderen Treibersignals (B; B, C) der zweiten Treiberschaltung (2; 2, 3) länger ist als die Anstiegszeit und Abfallzeit der genannten komplementären Treibersignale ($\overline{\text{A}}$, A) der ersten Treiberschaltung (1).

14. Eine Logikschaltung nach irgendeinem vorhergehenden Anspruch, bei der die Frequenz des genannten anderen Treibersignals (B; B, C) der zweiten Treiberschaltung (2; 2, 3) niedriger ist als die Frequenz der genannten komplementären Treibersignale ($\overline{\text{A}}$, A) der ersten Treiberschaltung (1).

15. Eine Logikschaltung nach Anspruch 1, bei der die genannten Transistoren (T₁, T₂, T₃, T₃') GaAs-FETs sind.

## Revendications

1. Circuit logique comprenant :
un amplificateur différentiel possédant une paire de transistors constituée d'un premier et d'un deuxième transistor (T₁, T₂) connectés à un étage de sortie (T₄, T₅) ;
un troisième transistor (T₃ ;T₃,T₃') connecté en parallèle avec le deuxième transistor (T₂) ; et
un premier circuit d'attaque (1) fonctionnellement connecté de façon à attaquer les premier et deuxième transistors (T₁, T₂) à l'aide de signaux d'attaque complémentaires ($\overline{\text{A}}$, A) ayant des premier et deuxième niveaux (L₁, H₁);
et où le troisième transistor (T₃ ; T₃, T₃') est destiné à être attaqué par un autre signal d'attaque (B; B, C) possédant des troisième et quatrième niveaux (L₂, H₂), le troisième niveau (par exemple H₂) se trouvant au-delà d'une extrémité de l'intervalle compris entre les premier et deuxième niveaux (L₁, H₁);
caractérisé en ce que :
un deuxième circuit d'attaque (2 ; 2 , 3) est fonctionnement connecté de façon à attaquer le troisième transistor (T₃ ; T₃, T₃') à l'aide dudit autre signal d'attaque (B ; B, C) ayant lesdits troisième et quatrième niveaux ;
lesdits premier et deuxième circuits d'attaque étant tous deux prévus indépendamment dudit amplificateur différentiel, sans être connectés à l'étage de sortie, de façon à permettre une sélection des niveaux desdits signaux d'attaque ($\overline{\text{A}}$, A ; B ; B, C) ;
et en ce que les niveaux desdits signaux d'attaque sont sélectionnés de façon que le quatrième niveau (par exemple L₂) soit sensiblement situé sur l'autre extrémité de l'intervalle compris entre les premier et deuxième niveaux (L₁, H₁) ou soit au-delà de cette autre extrémité.

2. Circuit logique selon la revendication 1, où le niveau haut (H₂) dudit autre signal d'attaque (B;B,C) du deuxième circuit d'attaque (2;2,3) est effectivement supérieur au niveau haut (H₁) desdits signaux d'attaquc complémentaires ($\overline{\text{A}}$, A) du premier circuit d'attaque (1).

3. Circuit logique selon la revendication 2, où le niveau bas (L₂) dudit autre signal d'attaque (B ; B, C) du deuxième circuit d'attaque est sensiblement égal au niveau bas (L₁) desdits signaux d'attaque complémentaires ($\overline{\text{A}}$, A) dudit premier circuit d'attaque (1).

4. Circuit logique selon la revendication 2, où le niveau bas (L₂) dudit autre signal d'attaque (B ; B, C) du deuxième circuit d'attaque (2 ; 2, 3) est inférieur au niveau bas (L₁) desdits signaux d'attaque complémentaires ($\overline{\text{A}}$, A) du premier circuit d'attaque (1).

5. Circuit logique selon la revendication 2, 3 ou 4, où lesdits transistors (T₁, T₂, T₃, T₃') sont des transistors NPN.

6. Circuit logique selon la revendication 1, où lesdits transistors (T₁, T₂, T₃, T₃') sont des transistors PNP et où le niveau bas (L₂) dudit autre signal d'attaque (B ; B, C) dudit deuxième circuit d'attaque (2 ; 2, 3) est effectivement inférieur au niveau bas (L₁) desdits signaux d'attaque complémentaires ($\overline{\text{A}}$, A) du premier circuit d'attaque (1).

7. Circuit logique selon la revendication 6, où le niveau haut (H₂) dudit autre signal d'attaque (B;B,C) du deuxième circuit d'attaque (2;2,3) est sensiblement égal au niveau haut (H₁) des signaux d'attaque complémentaires ($\overline{\text{A}}$, A) du premier circuit d'attaque (1).

8. Circuit logique selon la revendication 6, où le niveau haut (H₂) dudit autre circuit d'attaque (B;B,C) du deuxième circuit d'attaque (2;2,3) est supérieur au niveau haut (H₁) desdits signaux d'attaque complémentaires ($\overline{\text{A}}$, A) du premier circuit d'attaque (1).

9. Circuit logique selon l'une quelconque des revendications 5 à 8, où les émetteurs des premier, deuxième et troisième transistors (T₁, T₂, T₃, T₃') sont fonctionnement connectés entre eux et sont connectés à une source de courant sensiblement constant (IS3, IS1).

10. Circuit logique selon la revendication 9, où la source de courant sensiblement constant (IS3, IS1) comprend un quatrième transistor qui possède une résistance connectée en série avec une électrode d'émetteur de ce quatrième transistor et une tension sensiblement constante appliquée à une électrode de base de ce quatrième transistor.

11. Circuit logique selon la revendication 9, où la source de courant sensiblement constant (IS3, IS1) comprend une résistance.

12. Circuit logique selon l'une quelconque des revendications 5 à 11, où une résistance (R₁, R₂) est connectée entre une source d'alimentation électrique de collecteur (V_{CC}) et l'un des collecteurs des premier et deuxième transistors (T₁, T₂), si bien qu'un signal logique est délivré par le collecteur connecté à ladite résistance.

13. Circuit logique selon l'une quelconque des revendications précédentes, où le temps de montée et le temps de descente dudit autre signal d'attaque (B ; B, C) du deuxième circuit d'attaque (2 ; 2, 3) sont plus longs que le temps de montée et le temps de descente desdits signaux d'attaque complémentaires ($\overline{\text{A}}$, A) du premier circuit d'attaque (1).

14. Circuit logique selon l'une quelconque des revendications précédentes, où la fréquence dudit autre signal d'attaque (B ; B, C) du deuxième circuit d'attaque (2 ; 2, 3) est inférieure à la fréquence desdits signaux d'attaque complémentaires ($\overline{\text{A}}$, A) du premier circuit d'attaque (1).

15. Circuit logique selon la revendication 1, où lesdits transistors (T₁, T₂, T₃, T₃') sont des transistors à effet de champ en GaAs.
